Europäisches Patentamt

European Patent Office

Office européen des brevets

(19)

(11) **EP 0 808 512 B1**

(12) **EUROPÄISCHE PATENTSCHRIFT**

(45) Veröffentlichungstag und Bekanntmachung des Hinweises auf die Patenterteilung:
**21.09.2005 Patentblatt 2005/38**

(21) Anmeldenummer: **96945746.4**

(22) Anmeldetag: **21.11.1996**

(51) Int Cl.⁷: **H01L 27/02**, G11C 8/00

(86) Internationale Anmeldenummer:
**PCT/DE1996/002236**

(87) Internationale Veröffentlichungsnummer:
**WO 1997/021241 (12.06.1997 Gazette 1997/25)**

(54) **VERFAHREN ZUR ANSTEUERUNG EINES FELDEFFEKTTRANSISTORS**

METHOD OF DRIVING A FIELD EFFECT TRANSISTOR

PROCEDE POUR COMMANDER UN TRANSISTOR A EFFET DE CHAMP

(84) Benannte Vertragsstaaten:
**AT CH DE ES FR GB IT LI**

(30) Priorität: **06.12.1995 DE 19545558**

(43) Veröffentlichungstag der Anmeldung:
**26.11.1997 Patentblatt 1997/48**

(73) Patentinhaber: **Infineon Technologies AG
81669 München (DE)**

(72) Erfinder: **SEDLAK, Holger
81541 München (DE)**

(74) Vertreter: **Jannig, Peter et al
Jannig & Repkow,
Patentanwälte,
Klausenberg 20
86199 Augsburg (DE)**

(56) Entgegenhaltungen:
**EP-A- 0 472 095          US-A- 4 281 399**

**Beschreibung**

Die vorliegende Erfindung betrifft ein Verfahren zur Ansteuerung eines Feldeffekttransistors mit einem Sourceabschnitt, einem Drainabschnitt und einem Gateabschnitt, wobei an den Gateabschnitt eine Gatespannung angelegt wird, die die Ausbildung und/oder Aufrechterhaltung eines elektrisch leitenden Kanals zwischen dem Sourceabschnitt und dem Drainabschnitt bewirkt.

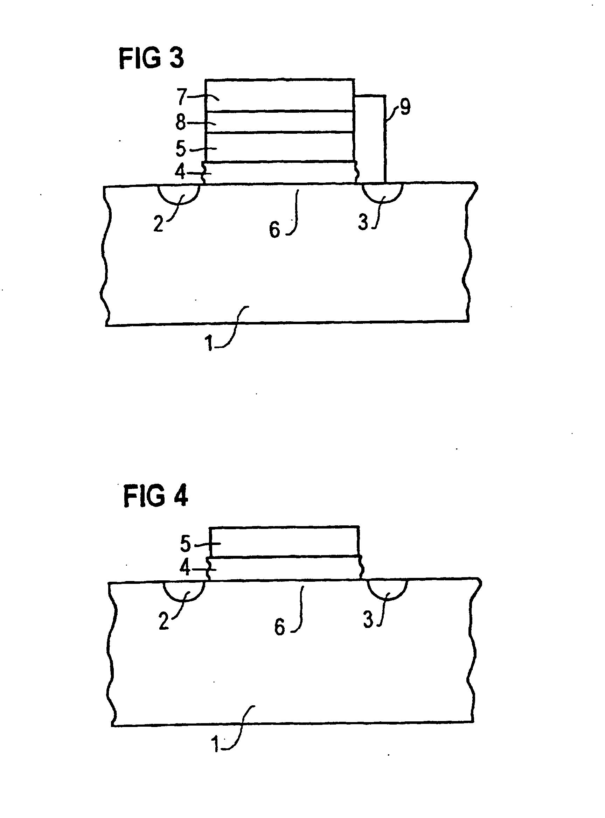

Derartige Feldeffekttransistoren (FETs) und Verfahren zu deren Ansteuerung sind seit langem bekannt. Ein praktisches Ausführungsbeispiel eines derartigen Transistors ist in Figur 4 gezeigt.

In Figur 4 ist schematisch ein herkömmlicher Anreicherungstyp-NMOS-FET dargestellt. Der gezeigte Transistor besteht aus einem aus p-dotiertem Halbleitermaterial gebildeten Substrat 1, einem an der Substratoberfläche vorgesehenen, aus n-dotiertem Halbleitermaterial gebildeten Sourceabschnitt 2, einem an der Substratoberfläche vorgesehenen, aus n-dotiertem Halbleitermaterial gebildeten Drainabschnitt 3, einer auf dem Substrat aufgebrachten Isolationsschicht 4, und einem über der Isolationsschicht vorgesehenen Gateabschnitt 5.

Legt man an den Gateabschnitt 5 eine positive Spannung, beispielsweise +5 V an, so werden zu dem dem Gateabschnitt gegenüberliegenden Bereich des Substrats (Kanalausbildungsbereich 6) aus den weiter vom Gateabschnitt entfernten Substratbereichen Elektronen angezogen. Der zunächst wegen der p-Dotierung einen Elektronenmangel aufweisende und folglich elektrisch nicht leitende Kanalausbildungsbereich 6 wird dadurch allmählich zu einem einen Elektronenüberschuß aufweisenden Bereich, der schließlich einen elektrisch leitenden Kanal zwischen dem Sourceabschnitt 2 und dem Drainabschnitt 3 bildet. Die Ausbildung eines derartigen Kanals bewirkt ein Durchschalten des Transistors, d.h. eine niederohmige elektrische Verbindung von Sourceabschnitt und Drainabschnitt.

Die Ausbildung bzw. Aufrechterhaltung des beschriebenen Kanals findet jedoch nur statt, wenn und solange die Gatespannung ($U_G$) einen gewissen Mindestwert aufweist, der unter anderem von der am Sourceabschnitt anliegenden Sourcespannung ($U_S$) und der am Drainabschnitt anliegenden Drainspannung ($U_D$) abhängt. Im stationären Betrieb des Transistors gilt dabei im wesentlichen die Bedingung, daß

$$U_G \geq \min (U_S, U_D) + U_T$$

erfüllt sein muß, wenn der Durchschaltzustand des Transistors erreicht bzw. aufrechterhalten werden soll, wobei $U_T$ eine materialabhängige Schwellen- bzw. Thresholdspannung für die Kanalbildung darstellt, die bei Feleffekttransistoren vom NMOS-Anreicherungstyp einen Wert von $U_T > 0$ V aufweist.

Es ist folglich bei herkömmlichen Feldeffekttransistoren im stationären Betrieb nicht möglich, eine an den Source- oder den Drainabschnitt angelegte Spannung durch eine gleich hohe oder niedrigere Gatespannung durchzuschalten. Die Gatespannung muß zu diesem Zweck vielmehr auf einen Pegel gebracht werden, der um mindestens $U_T$ über der durchzuschaltenden Spannung liegt.

Dies ist insbesondere in der Digitaltechnik, wo Feldeffekttransistoren vom Anreicherungstyp vorherrschen, mit nicht unerheblichen Schwierigkeiten verbunden, wenn Spannungspegel geschaltet werden sollen, die über der Versorgungsspannung liegen. Das Erzeugen eines zusätzlichen Spannungspegels zur Verwendung als Gatespannung erfolgt bisher mittels sogenannter Pumpen, welche eine Spannung mit niedrigem Pegel (bei Bedarf stufenweise) auf eine Spannung mit einem höheren Pegel anheben. Die schaltungstechnische Realisierung derartiger Pumpen erfordert eine Vielzahl von zusätzlichen elektronischen Bauelementen (insbesondere Transistoren und Kondensatoren), was vor allem bei integrierten Schaltungen nachteilig ist (fächenintensiv; Hoch- und Niedervoltflächen sind schwer zu trennen).

Weitere Verfahren sind in den Dokumenten US 4281399, EP472095 und JP4124835 beschrieben.

Der vorliegenden Erfindung liegt daher die Aufgabe zugrunde, das Verfahren zur Ansteuerung von Feldeffekttransistoren derart weiterzubilden, daß auf einfache Weise ein Durchschalten hoher Spannungen unter Verwendung gleich hoher oder niedrigerer Gatespannungen ermöglicht wird.

Diese Aufgabe wird erfindungsgemäß durch die in Patentanspruch 1 beanspruchten Merkmale gelöst.

Demnach ist vorgesehen, daß nach der Kanalausbildung der Gateabschnitt von einer diesen mit der Gatespannung beaufschlagenden Gatespannungs-Versorgungsquelle getrennt wird.

Das Vorsehen dieser Maßnahme ermöglicht es, das (jetzt floatende bzw. nicht mehr aktiv getriebene) Gatepotential mittels einer nach dem Abtrennen des Gateabschnittes von der Gatespannungs-Versorgungsquelle angelegten (durchzuschaltenden) Spannung auf ein das Potential der durchzuschaltenden Spannung übersteigendes Potential anzuheben, so daß ohne aufwendiges Generieren einer separaten Gatespannung auch Spannungen geschaltet werden können, die bei herkömmlicher Feldeffekttransistor-Ansteuerung mangels Erfüllbarkeit der Bedingung

$$U_G \geq \min (U_S, U_D) + U_T$$

nicht durchschaltbar sind.

Es wurde mithin ein Verfahren zur Ansteuerung von Feldeffekttransistoren geschaffen, das auf einfache Weise ein Durchschalten hoher Spannungen unter Verwendung gleich hoher oder niedrigerer Gatespannungen ermöglicht.

Vorteilhafte Weiterbildungen der Erfindung sind Gegenstand der Unteransprüche.

Das erfindungsgemäße Ansteuerverfahren ist darüber hinaus aufgrund des daraus resultierenden Verhaltens des angesteuerten Feldeffekttransistors auch noch in einer nicht übersehbaren Vielzahl weiterer Anwendungsfälle nutzbringend einsetzbar.

Die Erfindung wird nachfolgend anhand eines Ausführungsbeispiels unter Bezugnahme auf die Zeichnungen detailliert beschrieben. Es zeigen

Figur 1 eine Schaltung zur Erläuterung des erfindungsgemäßen Ansteuerverfahrens,

Figur 2 eine Darstellung, die die zeitlichen Signalverläufe an ausgewählten Punkten in der Schaltung gemäß Figur 1 veranschaulicht,

Figur 3 eine schematische Querschnittsansicht eines bei dem erfindungsgemäßen Ansteuerverfahren vorteilhaft einsetzbaren Feldeffekttransistors, und

Figur 4 eine schematische Querschnittsansicht eines herkömmlichen Feldeffekttransistors.

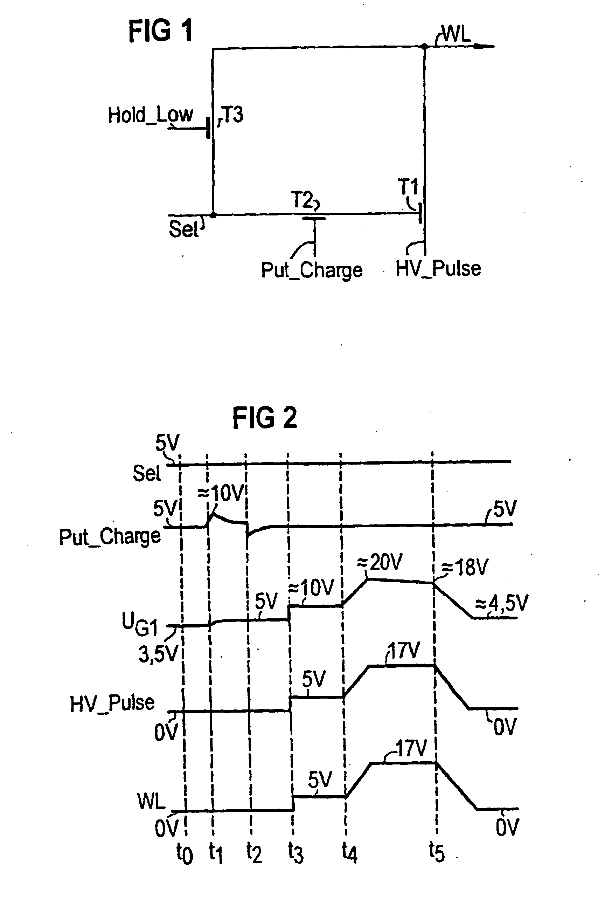

Die in der Figur 1 gezeigte Schaltung weist Anreicherungstyp-NMOS-Feldeffekttransistoren T1, T2 und T3 auf.

Vom Transistor T1 sind der Sourceabschnitt mit einer ein Signal HV_Pulse führenden Signalleitung, der Drainabschnitt mit einer ein Signal WL führenden Signalleitung und der Gateabschnitt mit dem Drainabschnitt des Transistors T2 verbunden.

Vom Transistor T2 sind der Sourceabschnitt mit einer ein Signal Sel führenden Signalleitung, der Drainabschnitt mit dem Gateabschnitt des Transistors T1 und der Gateabschnitt mit einer ein Signal Put_Charge führenden Signalleitung verbunden.

Vom Transistor T3 sind der Sourceabschnitt mit der das Signal Sel führenden Signalleitung, der Drainabschnitt mit der das Signal WL führenden Signalleitung und der Gateabschnitt mit einer ein Signal Hold_Low führenden Signalleitung verbunden.

Mittels des Signals HV_Pulse ist an den Sourceabschnitt des Transistors T1 eine Spannung anlegbar, die im beschriebenen Ausführungsbeispiel Werte zwischen 0 V und +17 V annehmen kann. ,

Mittels des Signals Sel ist an die Sourceabschnitte der Transistoren T2 und T3 eine Spannung anlegbar, die im beschriebenen Ausführungsbeispiel Werte von 0 V oder +5 V annehmen kann.

Mittels des Signals Hold_Low ist an den Gateabschnitt des Transistors T3 eine Spannung anlegbar, die im beschriebenen Ausführungsbeispiel Werte von 0 V oder +5 V annehmen kann.

Über die Signalleitung Put_Charge ist an den Gateabschnitt des Transistors T2 eine Spannung anlegbar, die im beschriebenen Ausführungsbeispiel Werte von 0 V oder +5 V annehmen kann.

Ziel ist es, durch den Transistor T1 dessen maximale Sourcespannung (17 V) zur Signalleitung WL durchzuschalten.

Bei Verwendung eines herkömmlichen Verfahrens zur Transistorsteuerung müßte hierfür an den Gateabschnitt des Transistors 1 eine Gatespannung $U_{G1}$ ≥ 17 V + $U_T$ angelegt werden.

Das erfindungsgemäße Verfahren beschreitet demgegenüber, wie nachfolgend unter Bezugnahme auf Figur 2 detailliert erläutert wird, einen anderen Weg.

In Figur 2 sind die zeitlichen Verläufe der Signale Sel, Put_Charge, HV_Pulse, WL sowie der zeitliche Verlauf des Potentials $U_{G1}$ des Gateabschnittes des Transistors T1 gezeigt.

Es sei angenommen, daß die Signale Sel und Put_Charge zu einem Ausgangszeitpunkt t0 jeweils auf 5 V liegen.

Da Put_Charge so groß wie Sel und mithin nicht gleich oder größer als Sel + $U_T$ ist, kann sich im Transistor T2 kein leitender Kanal zwischen dessen Sourceabschnitt und dessen Drainabschnitt ausbilden, so daß das Potential dessen Drainabschnittes und damit auch das Potential $U_{G1}$ des Gateabschnittes des Transistors T1 floatend (nicht aktiv getrieben) ist und zum betrachteten Zeitpunkt Put_Charge - $U_T$ (≈ 3,5 V) beträgt.

Die Tatsache, daß $U_{G1}$ = 3,5 V beträgt, hat zur Folge, daß sich der Transistor T1 im schwach leitenden Zustand befindet.

Wenn nun zum Zeitpunkt t1 Put_Charge wie in Figur 2 gezeigt auf beispielsweise 10 V ansteigt, so bildet sich im Transistor T2 ein leitender Kanal aus und dessen Sourcespannung (5 V) wird (gegebenenfalls mit einer gewissen zeitlichen Verzögerung) zu dessen Drainabschnitt bzw. zum Gateabschnitt des Transistors T1 durchgeschaltet.

Da das Signal HV_Pulse (Sourcespannung des Transistors T1) zum Zeitpunkt t1 0 V beträgt, bewirkt das Ansteigen der Gatespannung $U_{G1}$ des Transistors T1 auf +5 V, daß sich in diesem Transistor ein gut leitender Kanal ausbildet. Die Drainspannung bzw. das Signal WL bleiben bzw. werden dadurch auf 0 V gelegt.

Wenn nun mit dem Abschluß der Kanalausbildung in Transistor T1 oder beliebige Zeit danach Put_Charge wieder auf ca. 5 V oder eine niedrigere Spannung zurückfällt bzw. zurückgenommen wird (Zeitpunkt t2), führt dies zur Auflösung des leitenden Kanals im Transistor T2. Der Transistor T2 geht damit in den Sperrzustand über, so daß die über den Drainabschnitt des Transistors T2 verlaufende Verbindung zwischen dem Gateabschnitt des Transistors T1 und einer denselben mit einer Spannung beaufschlagenden Versorgungsquelle aufgetrennt ist.

Der Drainabschnitt des Transistors T2 und damit auch der Gateabschnitt des Transistors T1 ist in diesem Zustand daher floatend (nicht aktiv getrieben); diese Abschnitte behalten daher ihr vorheriges Potential von 5 V unverändert bei, so daß der im Transistor T1 gebildete Kanal unverändert aufrecht erhalten wird.

Nach Erlangung dieses Zustandes wird zum Zeitpunkt t3 HV_Pulse von 0 V auf 5 V gesetzt, die infolge der zuvor erfolgten Floatend-Schaltung des Gateabschnittes des Transistors T1 (und anders als bei herkömmlichen Ansteuerverfahren) vom Sourceabschnitt zum Drainabschnitt durchgeschaltet werden.

Noch bevor sich nämlich der Kanal auflösen kann (weil die Bedingung $U_{G1} \geq \min(U_{S1}, U_{D1}) + U_T$ nicht mehr erfüllt ist), steigt das Potential des Gateabschnittes des Transistors T1 um ca. 5 V auf ca. 10 V an, so daß die am Sourceabschnitt anliegenden 5 V durchgeschaltet werden können, ohne daß der Kanal zusammenbricht.

Die erwähnte selbständige Erhöhung des Gatepotentials am Transistor T1 läßt sich folgendermaßen erklären: Der Gateabschnitt und der diesem gegenüberliegende Substratabschnitt, in welchem auch der Kanal ausgebildet ist (sofern vorhanden) wirken wie Platten eines Kondensators. Die Platten befanden sich zum Zeitpunkt t2, als die eine der Platten (der Gateabschnitt) von der Versorgungsquelle getrennt wurde, im Gleichgewicht. Zu diesem Zeitpunkt, da die Sourcespannung (HV_Pulse) noch 0 V betrug, konnte über den Kanal kein Strom fließen. Dies änderte sich jedoch zum Zeitpunkt t3, als die Sourcespannung auf 5 V erhöht und über den weiterhin existierenden Kanal durchgeschaltet wurde. Das Durchschalten der 5 V bewirkte aufgrund der veränderten Ladungsträgermenge auf einer der Platten (im Kanal) eine Störung des Gleichgewichts im Kondensator. Um das Gleichgewicht wiederherzustellen, wurden auf die Platte mit den weniger Ladungsträgern (Gateabschnitt) zusätzliche Ladungsträger angezogen, was wiederum ausschlaggebend für die sich einstellende Potentialerhöhung ist.

Durch die gezielte Ausnutzung dieses bislang noch nicht erkannten Effekts kann ein Durchschalten des Transistors selbst dann bewerkstelligt werden, wenn die Bedingung

$$U_G \geq \min(U_S, U_D) + U_T$$

nicht erfüllbar zu sein scheint.

Im Ergebnis liegen ab dem Zeitpunkt t3 am Drainabschnitt des Transistors T1 (=Signalleitung WL) die vom Sourceabschnitt desselben durchgeschalteten 5 V an.

Die auf ca. 10 V angehobene Gatespannung $U_{G1}$ bleibt zumindest vorübergehend im wesentlichen unverändert erhalten.

Wenn zu einem (beliebigen) Zeitpunkt t4 die Sourcespannung des Transistors T1 (HV_Pulse) kontinuierlich ansteigend auf den Maximalwert von 17 V erhöht wird, erhöht sich dadurch infolge der vorstehend erläuterten Gründe die Gatespannung des Transistors T1 auf ca. 20 V, so daß auch die 17 V problemlos zum Drainabschnitt des Transistors T1 bzw. zur Signalleitung WL durchgeschaltet werden können.

Die Erhöhung der Sourcespannung des Transistors T1 auf den durchzuschaltenden Wert (hier von 0V auf 17 V) kann in beliebig vielen Etappen erfolgen, und zwar vorzugsweise stufenweise oder kontinuierlich ansteigend, gegebenenfalls jedoch auch sprungartig.

Das Durchschalten der 17 V wird entweder durch ein Abschalten der Sourcespannung (HV_Pulse) oder automatisch durch Zeitablauf beendet.

Die in der Figur 2 veranschaulichte Beendigung des Durchschaltens durch Zeitablauf tritt auf, weil vom Gateabschnitt infolge parasitärer Leckpfade (unerwünschte Kapazitäten zwischen Gateabschnitt und benachbarten elektrischen, elektromechanischen oder mechanischen Komponenten; im Ersatzschaltbild ein Kondensator vom Gateabschnitt gegen Masse) allmählich Ladungen abfließen und damit das Gatepotential schrumpft. So lange die Bedingung

$$U_{G1} \geq \min(U_{S1}, U_{D1}) + U_T$$

erfüllt ist, kann die Signalleitung WL mittels HV_Pulse wieder nach 0 V entladen werden (Zeitpunkt t5).

Bei entsprechender Ansteuerung des Transistors T3 kann die Signalleitung WL im Sperrzustand des Transistors T1 aktiv auf beliebige Spannungswerte getrieben werden.

Die Dauer, während der die Hochspannung (17 V) durch den Transistor T1 durchgeschaltet werden kann, hängt wesentlich davon ab, wie hoch das Gatepotential zum Zeitpunkt t3 ist, wie gut das Gatepotential einer Ladungsträgermengenerhöhung im Kanal folgen kann und wie schnell sich der auf Hochspannung angehobene Gateabschnitt entlädt.

Sind die zuletzt genannten Punkte bei einem herkömmlichen Transistor für eine beabsichtigte Anwendung nicht zufriedenstellend, so kann in Betracht gezogen werden, einen im Hinblick darauf optimierten Transistor zu verwenden.

Ein derartiger Transistor ist in der Figur 3 schematisch dargestellt.

Der in der Figur 3 gezeigte Feldeffekttransistor (Anreicherungstyp-NMOS-FET) weist ein Substrat 1, einen Sourceabschnitt 2, einen Drainabschnitt 3, einen Isolationsschicht 4, einen Gateabschnitt 5 und einen Kanalausbildungsbereich 6 auf.

Diese Elemente entsprechen den jeweiligen Elementen des vorstehend bereits beschriebenen herkömmlichen Feldeffekttransistors gemäß Figur 4 und werden daher nicht nochmals erläutert.

Im Unterschied zu dem in Figur 4 gezeigten Feldeffekttransistor weist der Feldeffekttransistor gemäß Figur 3 zusätzlich eine Gateabdeckung 7 auf.

Die Gateabdeckung 7 ist gemäß der Figur 3 an der vom Substrat 1 abgewandten Seite des Gateabschnitts 5 vorgesehen. Sie besteht aus elektrisch leitendem Material und ist über eine Verbindungsleitung 9 elektrisch mit dem Drainabschnitt 3 verbunden.

Zwischen dem Gateabschnitt 3 und der Gateabdeckung 7 ist eine dünne Isolationsschicht 8 (die Dicke bewegt sich vorzugsweise im nm- oder µm-Bereich) vorgesehen, um die Elemente elektrisch voneinander zu isolieren.

Die Gateabdeckung 7 bewirkt, daß das vorstehend detailliert erläuterte Ansteuerverfahren auch noch in solchen Fällen einsetzbar ist, bei denen sich der gewünschte Effekt anderenfalls nicht im benötigten Umfang und/oder der geforderten Zuverlässigkeit einstellen würde.

Diese Funktion der Gateabdeckung beruht im wesentlichen darauf, daß sie um den Gateabschnitt eine Abschirmung bildet, die im Gegensatz zu herkömmlichen Abschirmungen auf demselben Potential wie das Drainpotential liegt und mithin einerseits den selben positiven Effekt wie der Kanal bewirkt, und andererseits den Abfluß von Ladungen vom Gateabschnitt über parasitäre Kapazitäten (unerwünschte Kapazitäten zwischen Gateabschnitt und benachbarten elektrischen, elektromechanischen oder mechanischen Komponenten; im Ersatzschaltbild ein Kondensator vom Gateabschnitt auf Masse) zumindest einschränkt und zudem das Verhältnis von Nutzkapazität (Kapazitäten zwischen dem Gateabschnitt und dem Substrat sowie zwischen dem Gateabschnitt und der Gateabdeckung) zu parasitären Kapazitäten erhöht.

Die Gateabdeckung 7 ist gemäß Figur 3 nur oberhalb des Gateabschnittes 5 vorgesehen und deckt denselben daher nur auf der vom Substrat abgewandten Seite des Gateabschnittes ganz oder teilweise ab. Hierauf besteht jedoch keine Einschränkung. Die Gateabdeckung kann statt dessen oder zusätzlich auch die gemäß Figur 1 seitlichen Flächen des Gateabschnittes bedecken. Die beste Wirkung der Gateabdeckung stellt sich ein, wenn sämtliche dem Substrat nicht zugewandten Bereiche des Gateabschnittes (jeweils unter Zwischenschaltung der Isolationsschicht 8) von der Gateabdeckung umgeben sind.

Die Gateabdeckung ist gemäß Figur 3 elektrisch mit dem Drainabschnitt verbunden. Auch hierauf besteht keine Einschränkung. Eine im wesentlichen gleichartige Wirkung der Gateabdeckung kann auch erzielt werden, wenn die Gateabdeckung statt dessen mit dem Sourceabschnitt elektrisch verbunden ist.

Mit oder ohne Gateabdeckung fällt das auf die beschriebene Weise erhöhte Gatepotential des Transistors T1 allmählich wieder ab, was schließlich zu einem Zusammenbruch des Kanals (Sperren des Feldeffekttransistors) führt. Zwischen dem Trennen des Gateabschnittes von der Versorgungsquelle und dem Zusammenbruch des Kanals liegen je nach Gestaltung des Transistors Bruchteile von Sekunden bis zu mehreren Minuten oder gar Stunden. Während dieser Zeit ist der Transistor stationär betreibbar.

Der selbständige Zusammenbruch des Kanals ist eine der eingangs bereits erwähnten zusätzlichen nutzbringend einsetzbaren Wirkungen des erfindungsgemäßen Ansteuerverfahrens. Sie verleiht dem derart angesteuerten Transistor zusätzlich die Funktion eines Monoflops und eröffnet mithin völlig neue Einsatzgebiete für Transistoren.

Besondere Effekte können demnach also auch dadurch erzielt werden, daß die vorstehend bereits angesprochenen Gateabschnitts-Nutzkapazitäten (Kapazitäten zwischen dem Gateabschnitt und dem Substrat sowie gegebenenfalls zwischen dem Gateabschnitt und der Gateabdeckung) gezielt verändert bzw. auf bestimmte Werte eingestellt werden (beispielsweise durch Veränderung der Zusammensetzung und/oder der Dicke der jeweiligen Isolationsschichten (Isolationsschichten 4 und 8)), um so das zeitliche Verhalten des Feldeffekttransistors an die beabsichtigte Anwendung anpassen zu können.

Das erfindungsgemäße Ansteuerverfahren wurde vorstehend anhand eines Anreicherungstyp-NMOS-Feldeffekttransistors beschrieben. Es versteht sich jedoch von selbst, daß eine derartige Ansteuerung - gegebenenfalls nach entsprechender Anpassung an die jeweiligen Gegebenheiten - auch bei beliebigen anderen Arten von Feldeffekttransistoren realisierbar und nutzbringend einsetzbar ist.

## Patentansprüche

1. Verfahren zur Ansteuerung eines Feldeffekttransistors mit einem Sourceabschnitt (2), einem Drainabschnitt (3) und einem Gateabschnitt (5), wobei an den Gateabschnitt eine Gatespannung ($U_G$) angelegt wird, die die Ausbildung und/oder Aufrechterhaltung eines elektrisch leitenden Kanals zwischen dem Sourceabschnitt und dem Drainabschnitt bewirkt,

   wobei ein Feldeffekttransistor verwendet wird, bei welchem der Sourceabschnitt oder der Drainabschnitt mit einer die Oberseite und/oder die Seitenflächen des Gateabschnittes bedeckenden, elektrisch leitenden Gateabdeckung elektrisch verbunden ist, und

   wobei zum Durchschalten einer Spannung vom Sourceabschnitt zum Drainabschnitt, deren Anlegen an den Sourceabschnitt den Aufbau des elektrisch leitenden Kanals verhindert hätte oder den Zusammenbruch des elektrisch leitenden Kanals bewirken würde,

   - der Gateabschnitt nach der Ausbildung des elektrisch leitenden Kanals von einer den Gateabschnitt mit der Gatespannung beaufschlagenden Gatespannungs-Versorgungsquelle getrennt wird, so daß sich der Gateabschnitt danach in einem floatenden Zustand befindet und der im Feldeffekttransistor gebildete elektrisch leitende Kanal aufrecht erhalten wird, und

- der Sourceanschluß nach dem Trennen des Gateabschnittes von der Gatespannungs-Versorgungsquelle mit der durchzuschaltenden Spannung beaufschlagt wird.

2. Verfahren nach Anspruch 1,
**dadurch gekennzeichnet,**
**daß** das Abtrennen des Gateabschnittes (5) von der Gatespannungs-Versorgungsquelle derart durchgeführt wird, daß das Gatepotential ($U_G$) hierbei erhalten bleibt.

3. Verfahren nach einem der vorhergehenden Ansprüche,
**dadurch gekennzeichnet,**
**daß** zum Abtrennen des Gateabschnittes (5) von der Gatespannungs-Versorgungsquelle eine die elektrische Verbindung zwischen dem Gateabschnitt und der Gatespannungs-Versorgungsquelle unterbrechende Schaltvorrichtung verwendet wird.

4. Verfahren nach einem der vorhergehenden Ansprüche,
**dadurch gekennzeichnet,**
**daß** dafür gesorgt wird, daß die Sourcespannung und die Drainspannung bis zum Abtrennen des Gateabschnittes (5) von der Gatespannungs-Versorgungsquelle Werte aufweisen, die im Zusammenwirken mit der Gatespannung ($U_G$) die Ausbildung und/oder Aufrechterhaltung des elektrisch leitenden Kanals bewirken.

5. Verfahren nach einem der vorhergehenden Ansprüche,
**dadurch gekennzeichnet,**
**daß** die Sourcespannung stufenweise erhöht wird.

6. Verfahren nach einem der vorhergehenden Ansprüche,
**dadurch gekennzeichnet,**
**daß** die Sourcespannung kontinuierlich erhöht wird.

## Claims

1. Method for driving a field effect transistor having a source section (2), a drain section (3) and a gate section (5), a gate voltage ($U_G$) that causes an electrically conductive channel to be formed and/or maintained between the source section and the drain section being applied to the gate section, use being made of a field effect transistor, in which the source section or the drain section is electrically connected to an electrically conductive gate covering that covers the top side and/or the side areas of the gate section, and,
in order to switch through a voltage from the source section to the drain section, the application of which voltage to the source section would have prevented the electrically conductive channel from being set up or would have caused the electrically conductive channel to collapse,

- the gate section being isolated from a gate voltage supply source (which applies the gate voltage to the gate section) after the electrically conductive channel has been formed, with the result that the gate section is then in a floating state and the electrically conductive channel formed in the field effect transistor is maintained, and

- the voltage to be switched through being applied to the source terminal after the gate section has been isolated from the gate voltage supply source.

2. Method according to Claim 1,
**characterized in that**
the gate section (5) is isolated from the gate voltage supply source in such a manner that the gate potential ($U_G$) is maintained in this case.

3. Method according to one of the preceding claims,
**characterized in that**,
in order to isolate the gate section (5) from the gate voltage supply source, use is made of a switching device that interrupts the electrical connection between the gate section and the gate voltage supply source.

4. Method according to one of the preceding claims,
**characterized in that**
it is ensured that, until the gate section (5) is isolated from the gate voltage supply source, the source voltage and the drain voltage have values which, in combination with the gate voltage ($U_G$), cause the electrically conductive channel to be formed and/or maintained.

5. Method according to one of the preceding claims,
**characterized in that**
the source voltage is increased in steps.

6. Method according to one of the preceding claims,
**characterized in that** the source voltage is increased continuously.

**Revendications**

1.  Procédé pour commander un transistor à effet de champ qui présente une partie de source (2), une partie de drain (3) et une partie de grille (5), une tension de grille ($U_G$) étant appliquée sur la partie de grille et ayant pour effet la formation et/ou le maintien d'un canal électriquement conducteur entre la partie de source et la partie de drain,

    dans lequel on utilise un transistor à effet de champ dont la partie de source ou la partie de drain sont reliées électriquement à un recouvrement de grille électriquement conducteur qui recouvre le côté et/ou les surfaces latérales de la partie de grille,

    dans lequel pour faire passer une tension de la partie de source à la partie de drain, tension dont l'application à la partie de source a empêché l'établissement du canal électriquement conducteur ou a eu pour effet la disparition du canal électriquement conducteur,

    -   après la formation du canal électriquement conducteur, la partie de grille est séparée d'une source d'alimentation de tension de grille qui alimente la partie de grille en tension de grille, de telle sorte qu'ensuite la partie de grille se trouve à un état flottant et que le canal électriquement conducteur formé dans le transistor à effet de champ est maintenu, et
    -   après la séparation de la partie de grille vis-à-vis de la source d'alimentation de tension de grille, le raccordement de source est alimenté en la tension qui doit être passée.

2.  Procédé selon la revendication 1, **caractérisé en ce que** la séparation de la partie de grille (5) vis-à-vis de la source d'alimentation de tension de grille est réalisée de telle sorte qu'à cette occasion, le potentiel de grille ($U_G$) soit maintenu.

3.  Procédé selon l'une des revendications précédentes, **caractérisé en ce que** pour séparer la partie de grille (5) de la source d'alimentation en tension de grille, on utilise un dispositif de commutation qui interrompt la liaison électrique entre la partie de grille et la source d'alimentation en tension de grille.

4.  Procédé selon l'une des revendications précédentes, **caractérisé en ce que** jusqu'à la séparation de la partie de grille (5) vis-à-vis de la source d'alimentation en tension de grille, on assure que la tension de source et la tension de drain présentent des valeurs qui ont pour effet, en coopération avec la tension de grille ($U_G$), la formation et/ou le maintien du canal électriquement conducteur.

5.  Procédé selon l'une des revendications précédentes, **caractérisé en ce que** la tension de source est relevée par gradins.

6.  Procédé selon l'une des revendications précédentes, **caractérisé en ce que** la tension de source est relevée de manière continue.

## FIG 1

## FIG 2

## FIG 3

## FIG 4